# EUROPEAN PATENT SPECIFICATION

(11) **EP 2 128 909 B1**
(45) Date of publication and mention of the grant of the patent: **02.05.2018**
(21) Application number: 09170922.0
(22) Date of filing: 10.11.2005
(51) Int. Cl.: H01L 51/44, H01L 51/52

(54) **Sealant pattern for flat display panel**
Strukturierte Verkapselung für einen Flachbildschirm
Scellement structuré pour écran plat

(30) Priority: 22.11.2004 KR 20040095942
(43) Date of publication of application: 02.12.2009
(62) Divisional of application: 05110595.5
(73) Proprietor: Samsung Display Co., Ltd., Gyeonggi-do (KR)
(72) Inventor: LEE, Sun-Youl, Gyeonggi-do (KR)
(74) Representative: Gulde & Partner

(56) References cited:
- JP-A- 61 241 730
- JP-A- 2001 155 855
- JP-A- 2004 311 385
- US-A1- 2004 171 184
- US-B1- 6 791 660

## Description

### BACKGROUND OF THE INVENTION

### Field of the Invention

The present invention relates to a flat display panel, and more particularly, to a sealant having protrusion parts on corners of a substrate and an Organic Light Emitting Diode (OLED) using the sealant.

### Description of the Related Art

Light emitting diodes are classified into inorganic Light Emitting Diodes (LEDs) and Organic Light Emitting Diodes (OLEDs) according to the kind of light emitting compound used to form an organic film layer between an anode electrode and a cathode electrode. inorganic LEDs have a long lifetime, but have low light emission efficiency and a high driving voltage. On the other hand, OLEDs have high light emitting efficiency and a low driving voltage, but have a short lifetime.

An OLED includes anode electrodes arranged in one direction, cathode electrodes arranged to cross the anode electrodes, and organic light emitting layers interposed between the anode electrodes and the cathode electrodes on a substrate. An OLED is an emissive device, that is, it includes an organic light emitting layer that emits light according to the voltages supplied to the anode electrode and the cathode electrode.

OLEDs are widely used since they have a high resolution and a high impact resistance, and can realize a full color image. However, after a prolonged period of driving, OLEDs not only suffer from severe degradation of light emission characteristics, such as brightness and uniformity of light, but also have a short lifespan.

One of the causes of the degradation of the light emission characteristics and the short lifespan is the separation of the organic film layer from the electrodes due to moisture absorbed by the organic film layer and penetrating into the OLED through a defective portion or an edge of the OLED. The separation of the organic film layer from the electrodes produces dark points which do not emit light.

In the prior art, to prevent the degradation of the characteristics and the reduction of lifespan of an OLED by moisture and air, a substrate on which the OLED is formed, that is, an array substrate, is sealed by a sealing member using a sealant. However, in the case of an OLED in which the substrate is sealed by the sealing member using the sealant, the characteristics are degraded or the lifespan is reduced due to the moisture and oxygen penetrating from the outside or already absorbed in the organic film layer.

In the prior art, to maintain the characteristics and to extend the lifespan of an OLED by preventing defects such as dark points caused by the penetration of moisture and air, a protection film is formed on the entire surface of the substrate on which the OLED is formed or a substrate on which the OLED is sealed by a sealing substrate that includes a moisture absorbing material using a sealant.

Japanese Laid -Open Patent No. 2002-184569 relates to an organic light emitting display device having a sealing structure for preventing the penetration of oxygen and moisture by forming a metal absorption film on the OLED after a substrate, on which the OLED has been formed, is sealed by a sealing substrate using a sealant.

Japanese Laid -Open Patent No. 2002-280169 relates to an organic light emitting display device having an OLED within an inner barrier rib of a frame-type and having an outer barrier rib of a frame-type formed along the inner barrier rib of a frame-type. The reliability of the organic light emitting display device is improved by reducing the penetration of moisture by bonding an upper substrate and a lower substrate using an adhesive filled between the inner barrier rib of a frame-type and the outer barrier rib of a frame-type.

However, in the above-noted organic light emitting display device, the sealant pattern for sealing upper and lower substrates has a frame-type. Therefore, the upper and lower substrates can be easily exfoliated by impacts on the corners of the substrates, thereby reducing the reliability and lifespan of the device. Particularly, in a flexible organic light emitting display device, the separation is severe at the edge portions of the panel due to bending of the substrate. Other related documents are JP 2004 311385 A, US 2004/171184 A1 and US 6 791 660 B1.

### SUMMARY OF THE INVENTION

The present invention is defined in claim 1.

A flat display device is provided including: a substrate including an image display unit on which display devices are arranged; and a sealing member adapted to seal the substrate with a sealant, the sealant including a frame portion adapted to surround the image display unit and protrusion portions protruding from the frame portion at the corners of the substrate.

The frame portion of the sealant includes frame members. The frame portion of the sealant preferably includes angled or rounded corners.

The protrusion portions comprise first and second bar pattern shaped parts, the first bar pattern shaped part extending parallel to a first adjacent frame portion and the second bar pattern shaped part extending parallel to a second adjacent frame portion.

The flat display device further includes an organic light emitting display device.

The sealant is selected from the group consisting of a thermosetting resin, an ultraviolet setting resin, and a thermoplastic resin.

The flat display device preferably further includes a flexible display device including a flexible substrate as the substrate and the sealing member.

### BRIEF DESCRIPTION OF THE DRAWINGS

A more complete appreciation of the present invention, and many of the attendant advantages thereof, will be readily apparent as the present invention becomes better understood by reference to the following detailed description when considered in conjunction with the accompanying drawings in which like reference symbols indicate the same or similar components, wherein:
FIG. 1 is a plan view of an organic light emitting display device according to an embodiment of the present invention;
FIG. 2 is a cross-sectional view taken along line II-II of FIG. 1; and
FIG. 3 is a plan view of an organic light emitting display device useful for understanding the present invention.

### DETAILED DESCRIPTION OF THE INVENTION

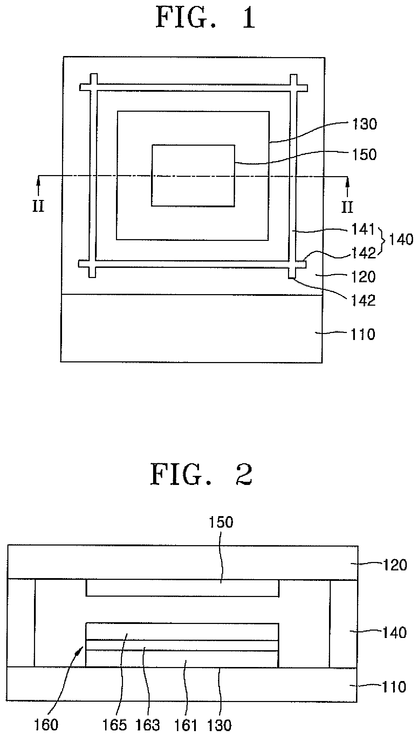

The present invention is described more fully below with reference to Fig. 1 and 2 in which exemplary embodiments of the invention are shown.

FIG. 1 is a plan view of an organic light emitting display device according to an embodiment of the present invention.

Referring to FIG. 1, an organic light emitting display device according to an embodiment of the present invention includes a substrate 110 having an image display unit 130. Organic Light Emitting Diodes (OLEDs) are arranged on the image display unit 130 of the substrate 110. The substrate 110 can be a glass substrate or a flexible substrate. The organic light emitting display device includes a flexible display device that uses a flexible substrate as the substrate 110.

The flexible substrate can be formed of a polymer plastic film, and is preferably formed of a film having high heat resistance to withstand the temperatures used in manufacturing the display device. The flexible substrate can be formed of polyethersulphone (PES), polyacrylate (PAR), polyetherimide (PEI), polyethylene napthalate (PEN), polyethylene terephthalate (PET).

The OLEDs arranged on the substrate 110 are sealed by a sealing member 120. The sealing member 120 includes a glass substrate, a metal cap, or a synthetic resin film. Also, the sealing member 120 can include a flexible substrate like the substrate 110. An absorbent 150 for absorbing moisture or oxygen contained in the air between the substrate 110 and the sealing member 120 is attached to the sealing member 120. The absorbent 150 can include silica, synthetic zeolite, P₂O₅, or BaO, or can include an absorbent that hardens by heat or ultraviolet rays.

The substrate 110 and the sealing member 120 are bonded by a sealant 140. The sealant 140 includes a frame portion 141 having a frame shape that surrounds the image display unit 130 along the edges of the substrate 110 or the sealing member 120 and protrusion portions 142 having a bar shape protruding from the corners of the frame portion 141. The frame portion 141 can have an angled corner frame shape or a rounded corner frame shape. The size of the protrusion portions 142 is determined by the size of a region on which the sealant 140 is coated and is a few hundred micrometers.

The sealant 140 can include a thermosetting resin, an ultraviolet ray setting resin, and a thermoplastic resin. The thermosetting sealant can include resins of phenols, epoxies, polyurethanes, and polyesters.

In the present embodiment, the frame portion 141 of the sealant 140 has a frame shape surrounding the image display unit 130 along the edges of the substrate 110 or the sealing member 120. However, the present invention is not limited thereto. That is, the frame portion 141 of the sealant 140 can be arranged in any form along the edges of the substrate 110 or the sealing member 120.

Also, in the present embodiment, the protrusion portions 142 includes two bar patterns protruding from the corners of the frame portion 141 and the protrusion portions 142 have the same width of the frame portion 141. However, the present invention is not limited thereto. The protrusion portions 142 can include at least one bar pattern protruding from the corners of the frame portion 141, and the width of the bar pattern can vary independently of the width of the frame portion 141.

FIG. 2 is a cross-sectional view taken along line II-II of FIG. 1. Referring to FIG. 2, in the organic light emitting display device according to the present invention, OLEDs 160 are arranged in the image display unit 130 of the substrate 110. The OLEDs 160 includes a lower electrode 161, an organic thin film layer 163, and an upper electrode 165. The organic thin film layer 163 includes at least one organic film selected from among a hole injection layer, a hole transport layer, a light emitting layer, an electron transport layer, an electron injection layer, and a hole blocking layer. The lower electrode 161 and the upper electrode 165 include a transparent electrode or an non-transparent electrode according to the direction of light emitted from the light emitting layer.

If the organic light emitting display device is an active matrix type, a thin film transistor (not shown) for driving the organic light emitting diode can also be included.

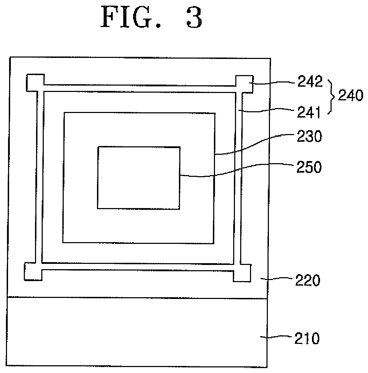

FIG. 3 is a plan view of an organic light emitting display device useful for understanding the present invention.

Referring to FIG. 3, an organic light emitting display device includes a substrate 210 having an image display unit 230 and a sealing member 220 for sealing the image display unit 230 of the substrate 210. As depicted in FIG. 2, OLEDs are arranged in the image display unit 230 of the substrate 210.

The substrate 210 can be a glass substrate or a flexible substrate. The flexible substrate can be formed of polyethersulphone (PES), polyacrylate (PAR), polyetherimide (PEI), polyethylene napthalate (PEN), polyethylene terephthalate (PET).

The sealing member 220 can be a glass substrate, a metal cap, or a synthetic resin film. An absorbent 250 for absorbing moisture or oxygen contained in the air between the substrate 210 and the sealing member 220 is attached to the sealing member 220. The absorbent 250 can include silica, synthetic zeolite, P₂O₅, or BaO, or can include an absorbent that hardens by heat or ultraviolet rays.

The substrate 210 and the sealing member 220 are bonded by a sealant 240. The sealant 240 includes a frame portion 241 having a frame shape that surrounds the image display unit 230 along the edges of the substrate 210 or the sealing member 220 and protrusion portions 242 having a block shape protruding from the corners of the frame portion 241. The frame portion 241 can have an angled corner frame shape or a rounded corner frame shape. The protrusion portions 242 can be formed in a rectangular shape or a circle shape. The size of the protrusion portions 242 is determined by the size of a region on which the sealant 240 is coated and is a few hundred micrometers.

The sealant 240 can include a thermosetting resin, an ultraviolet ray setting resin, and a thermoplastic resin. The thermosetting sealant can include resins of phenols, epoxies, polyurethanes, and polyesters.

The frame portion 241 of the sealant 240 has a frame shape surrounding the image display unit 230 along the edges of the substrate 210 or the sealing member 220.

Also, the protrusion portions 242 have a pattern having a block shape protruding from one corner of the frame portion 241.

The organic light emitting display device has a cross-sectional structure as depicted in FIG. 2.

Also a sealant pattern is proposed in the organic light emitting display device for sealing the substrate, on which light emitting diodes such as the OLEDs are arranged, using a sealing member.

In the present embodiments, the bonding force between the upper and lower substrates is increased by including protrusion portions of the sealant at the corners of the substrate. As described above, the organic light emitting display device according to the present invention increases the bonding force between the substrate and the sealing member by including protrusion portions of the sealant at the corners of the substrate and prevents the separation of the substrate at the corners. Accordingly, the reliability and lifespan of the organic light emitting display device can be improved since defects, such as dark points, due to the penetration of oxygen or moisture, can be prevented.

Also, when applied to a flexible organic light emitting display device, the organic light emitting diode can be protected from separation of panel edges due to bending of the substrate, and can provide a sufficient bonding force between the upper and lower substrates of a large display.

## Claims

1. A flat display device, comprising:
a substrate (110) having an rectangular shape and including an image display unit (130) on which display devices are arranged, wherein organic light emitting diodes (160) are arranged in the image display unit (130) of the substrate (110) and the organic light emitting diodes (160) include a lower electrode (161), an organic thin film layer (163), and an upper electrode (165);
a sealing member (120) with an attached absorbent (150) adapted for absorbing moisture or oxygen contained in the air between the substrate (110) and the sealing member (120); wherein the sealing member (120) is sealed to the substrate (110) with a sealant (140), the sealant (140) including a frame portion (141) consisting of four bar shaped frame members (141) arranged such to form an rectangle which surrounds the image display unit (130),
wherein the substrate (110) comprises a top surface and the sealing member (120) includes a substrate, and
the sealant (140) consists of one material which is selected from the group consisting of a thermosetting resin, an ultraviolet setting resin, and a thermoplastic resin, and wherein the frame portion (141) of the sealant (140) comprises a cross-section having a rectangular shape, and
an upper surface of the frame portion (141) is bonded to the substrate of the sealing member (120) and a lower surface of the frame portion (141) is bonded to the top surface of the substrate (110),
**characterized in that**
the sealant (140) further comprises four protrusion portions (142) adapted for preventing the separation from the sealing member (120) of the substrate (110) at corners of the substrate (110), wherein the protrusion portions (142) are protruding from the frame portion (141) at corners of the substrate (110),
wherein the protrusion portions (142) are arranged at each corner of the four bar shaped frame members (141), and
wherein each protrusion portion (142) comprises first and second bar pattern shaped parts protruding from corners of the frame portion (141).

2. The flat display device of claim 1, wherein the frame portion (141) of the sealant (140) comprises angled or rounded corners.

3. The flat display device of claim 1, further comprising a flexible display device including a glass substrate or a flexible substrate as the substrate (110) and the sealing member (120).

## Patentansprüche

1. Eine Flachanzeigevorrichtung, aufweisend:
ein Substrat (110), das eine rechteckige Form aufweist und eine Bildanzeigeeinheit (130), auf der Anzeigevorrichtungen angeordnet sind, aufweist, wobei organische lichtemittierende Dioden (160) in der Bildanzeigeeinheit (130) des Substrats (110) angeordnet sind und die organischen lichtemittierenden Dioden (160) eine untere Elektrode (161), eine organische Dünnfilmschicht (163) und eine obere Elektrode (165) aufweisen;
ein Dichtelement (120) mit einem befestigten Absorptionsmittel (150), das zum Absorbieren von Feuchtigkeit oder Sauerstoff, die in der Luft zwischen dem Substrat (110) und dem Dichtelement (120) enthalten sind, angepasst ist; wobei das Dichtelement (120) mit einem Dichtmittel (140) mit dem Substrat (110) dichtend verbunden ist, wobei das Dichtmittel (140) einen Rahmenabschnitt (141) aufweist, der aus vier stabförmigen Rahmenelementen (141) besteht, die derart angeordnet sind, dass sie ein Rechteck, das die Bildanzeigeeinheit (130) umgibt, ausbilden,
wobei
das Substrat (110) eine Oberseite aufweist und das Dichtelement (120) ein Substrat aufweist, und
das Dichtmittel (140) aus einem Material, das aus der Gruppe bestehend aus einem in Wärme härtbaren Harz, einem unter ultravioletter Strahlung härtbaren Harz und einem thermoplastischen Harz ausgewählt ist, besteht, und wobei der Rahmenabschnitt (141) des Dichtmittels (140) einen Querschnitt, der eine rechteckige Form aufweist, aufweist, und
eine Oberseite des Rahmenabschnitts (141) mit dem Substrat des Dichtelements (120) verbunden ist und eine Unterseite des Rahmenabschnitts (141) mit der Oberseite des Substrats (110) verbunden ist,
**dadurch gekennzeichnet, dass**
das Dichtmittel (140) weiterhin vier Vorsprungsabschnitte (142), die angepasst sind, um die Trennung des Substrats (110) vom Dichtelement (120) an Ecken des Substrats (110) zu verhindern, aufweist, wobei die Vorsprungsabschnitte (142) vom Rahmenabschnitt (141) an Ecken des Substrats (110) vorstehen,
wobei die Vorsprungsabschnitte (142) an jeder Ecke der vier stabförmigen Rahmenelemente (141) angeordnet sind, und
wobei jeder Vorsprungsabschnitt (142) einen ersten und zweiten stabförmigen Teil, die von Ecken des Rahmenabschnitts (141) vorstehen, aufweist.

2. Die Flachanzeigevorrichtung nach Anspruch 1, wobei der Rahmenabschnitt (141) des Dichtmittels (140) abgewinkelte oder gerundete Ecken aufweist.

3. Die Flachanzeigevorrichtung nach Anspruch 1, weiterhin aufweisend eine flexible Anzeigevorrichtung, die ein Glassubstrat oder ein flexibles Substrat als Substrat (110) und das Dichtelement (120) aufweist.

## Revendications

1. Dispositif d'affichage plat, comprenant :
un substrat (110) ayant une forme rectangulaire et comportant une unité d'affichage d'image (130) sur laquelle des dispositifs d'affichage sont agencés, où des diodes électroluminescentes organiques (160) sont agencées dans l'unité d'affichage d'image (130) du substrat (110) et les diodes électroluminescentes organiques (160) comportent une électrode inférieure (161), une couche de film mince organique (163) et une électrode supérieure (165) ;
un élément d'étanchéité (120) auquel est fixé un absorbant (150) adapté pour absorber l'humidité ou l'oxygène contenu(e) dans l'air entre le substrat (110) et l'élément d'étanchéité (120) ; où l'élément d'étanchéité (120) est scellé au substrat (110) avec un produit d'étanchéité (140), le produit d'étanchéité (140) comportant une partie de cadre (141) constituée de quatre éléments de cadre en forme de barres (141) agencés de manière à former un rectangle qui entoure l'unité d'affichage d'image (130),
où le substrat (110) comprend une surface de dessus et l'élément d'étanchéité (120) comporte un substrat, et
le produit d'étanchéité (140) est constitué d'un matériau qui est choisi dans le groupe consistant en une résine thermodurcissable, une résine durcissable aux ultraviolets et une résine thermoplastique, et où la partie de cadre (141) du produit d'étanchéité (140) comprend une section transversale ayant une forme rectangulaire, et
une surface supérieure de la partie de cadre (141) est collée au substrat de l'élément d'étanchéité (120) et une surface inférieure de la partie de cadre (141) est collée à la surface de dessus du substrat (110),
**caractérisé en ce que** :
le produit d'étanchéité (140) comprend en outre quatre parties en saillie (142) adaptées pour empêcher la séparation de l'élément d'étanchéité (120) du substrat (110) au niveau des coins du substrat (110), où les parties en saillie (142) font saillie à partir de la partie de cadre (141) au niveau des coins du substrat (110),
où les parties en saillie (142) sont agencées au niveau de chaque coin des quatre éléments de cadre en forme de barres (141), et
où chaque partie en saillie (142) comprend des première et deuxième parties en forme de motifs en barres faisant saillie à partir des coins de la partie de cadre (141) .

2. Dispositif d'affichage plat de la revendication 1, dans lequel la partie de cadre (141) du produit d'étanchéité (140) comprend des coins angulaires ou arrondis.

3. Dispositif d'affichage plat de la revendication 1, comprenant en outre un dispositif d'affichage flexible comportant un substrat en verre ou un substrat flexible en tant que substrat (110) et l'élément d'étanchéité (120).
